Europäisches Patentamt

European Patent Office

Office européen des brevets

(19)

(11) Veröffentlichungsnummer: **0 030 529**
**B1**

# (12) EUROPÄISCHE PATENTSCHRIFT

(45) Veröffentlichungstag der Patentschrift:
14.03.84

(21) Anmeldenummer: 80890140.9

(22) Anmeldetag: 28.11.80

(51) Int. Cl.³: **H 05 K 9/00**

(54) Abschirmtüre.

(30) Priorität: 10.12.79 AT 7780/79

(43) Veröffentlichungstag der Anmeldung:
17.06.81 Patentblatt 81/24

(45) Bekanntmachung des Hinweises auf die Patenterteilung:
14.03.84 Patentblatt 84/11

(84) Benannte Vertragsstaaten:
CH DE GB IT LI

(56) Entgegenhaltungen:
US - A - 3 691 688
US - A - 4 177 353

(73) Patentinhaber: SIEMENS AKTIENGESELLSCHAFT
ÖSTERREICH, Siemensstrasse 88 - 92, A-1210 Wien (AT)

(72) Erfinder: Pohl, Ulrich, Eisteichstrasse 10, A-1110 Wien
(AT)

(74) Vertreter: Pater, Max, Dr., c/o Siemens
Aktiengesellschaft Österreich Patente und Verträge
Bau 33 Siemensstrasse 88-92, A-1210 Wien (AT)

Abschirmtüre

Die Erfindung betrifft eine metallische Abschirmtür, insbesondere zur Abschirmung elektromagnetischer Störfelder, bei der das Türblatt an seinem unteren Ende mit einem Abschirmelement versehen ist, das an seiner der Türschwelle zugewendeten Fläche ein bei der Schließung der Tür, an die Türschwelle andrückbares federndes Kontaktelement trägt, wobei die Andrückung durch kraftübertragende Hilfsmittel erfolgt. Eine solche Abschirmtür ist aus der US-A-3 691 688 bekannt. Abschirmtüren für Störfelder sind bereits in großer Zahl bekannt geworden und werden in erster Linie in Meßanlagen zur Feldvermessung, Feldverteilung und auch zu Empfindlichkeitsmessungen an elektronischen Geräten benötigt. Neben diesen Anwendungsbereichen bestehen naturgemäß zahlreiche andere Sonderfälle, auf die nicht gesondert eingegangen werden soll.

Ein besonderes Problem bei der Verwendung derartiger Abschirmtüren ist der Einsatz bei Untersuchungen im Bereich von hohen und höchsten Frequenzen, etwa im Mikrowellenbereich. Es ist bekannt, daß leitende flächenhafte Elemente, wie etwa die Türblätter, wenn sie mit einer auch nur geringen Öffnung versehen sind, nach dem Babinet'schem Theorem mit ihren Öffnungen komplementäre Antennen darstellen, so daß der absolut dichte Verschluß dieser Öffnungen von ausschlaggebender Bedeutung ist.

Demgemäß sind Türkonstruktionen mit Vertikalhebelmechanismen für die beweglichen Türblätter und daran angeordneten federnden Kontaktelementen bereits ebenso bekannt, wie labyrinthähnliche Abschirmgänge, die jedoch entweder aufwendige mechanische Konstruktionen darstellen oder nicht zu unterschätzende Hindernisse bei rascher Betätigung darstellen.

Aus der US-A-3 691 688 ist eine metallische Abschirmtür, insbesondere zur Abschirmung elektromagnetischer Felder, bekannt, bei der das Türblatt an seiner der Türöffnung zugewendeten Fläche auf dem den Türrahmen überlappenden Teil ein Abschirmelement trägt. Nachteilig dabei ist die Stufe der Türschwelle, die einerseits eine Unfallgefahr, beispielsweise durch Stolpern birgt und andererseits das Einfahren in den Schirmraum mit Meßgerätewagen erschwert.

Die Erfindung hat sich die Aufgabe gestellt, nicht nur eine völlig sichere einfache Schließung des Türspalts unter Vermeidung einer Stufe als Türschwelle zu ermöglichen, sondern darüber hinaus auch eine jederzeit mögliche Öffnungsmöglichkeit — etwa bei plötzlich auftretenden Notfällen — zu gewährleisten.

Die Erfindung besteht darin, daß das Abschirmelement ein am unteren Ende des Türblatts mit einem um eine längs dessen Ende verlaufende Achse schwenkbar realisiert ist.

Nach einer vorteilhaften Ausführungsform der Erfindung wird als kraftübertragendes und krafterzeugendes Element eine elektrohydraulische, vorzugsweise elektropneumatische Vorrichtung vorgesehen, welche beispielsweise an der Fläche des Türblattes befestigt ist und durch ein mechanisch wirkendes Gestänge die Drehung des Abschirmelementes um seine Längsachse bewirkt. Anstelle der beschriebenen elektropneumatischen Vorrichtung können ebenso rein mechanisch wirkende Stellglieder, beispielsweise Handhebel oder federnde Kraftspeicher mit elektrischer Auslösung vorgesehen werden.

Ein Ausführungsbeispiel einer erfindungsgemäßen Einrichtung ist in den Zeichnungen dargestellt.

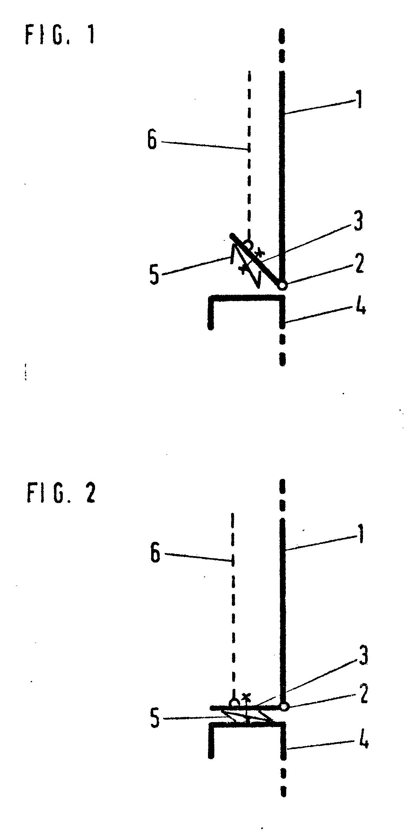

In F i g. 1 ist das Abschirmelement in geöffnetem, in Figur 2 in geschlossenem Zustand dargestellt.

Das Türblatt 1 trägt an seinem unteren Ende die Blattachse 2 für das schwenkbare Abschirmelement 3, welches an seiner der Türschwelle 4 zugekehrten Seite mit der Kontaktfeder 5, welche eine völlige Abdichtung beim Anpressen des schwenkbaren Abschirmelements 3 an die Türschwelle 4 gewährleistet, versehen ist. Durch die in der Zeichnung nicht näher dargestellte, auf das schwenkbare Abschirmelement 3 wirkende Kraftübertragungseinrichtung 6 erfolgt die Verschwenkung des Abschirmelements 3, so daß sich der in Figur 2 dargestellte geschlossene Zustand ergibt.

**Patentansprüche**

1. Metallische Abschirmtür, insbesondere zur Abschirmung elektromagnetischer Störfelder, bei der das Türblatt (1) an seinem unteren Ende mit einem Abschirmelement (3) versehen ist, das an seiner der Türschwelle (4) zugewendeten Fläche ein bei der Schließung der Tür, an die Türschwelle andrückbares federndes Kontaktelement (5) trägt, wobei die Andrückung durch kraftübertragende Hilfsmittel erfolgt, dadurch gekennzeichnet, daß das Abschirmelement (3) am unteren Ende des Türblatts (1) um eine längs dessen Ende verlaufende Achse (2) schwenkbar realisiert ist.

2. Metallische Abschirmtür nach Anspruch 1, dadurch gekennzeichnet, daß als krafterzeugendes Element eine elektrohydraulische, vorzugsweise elektropneumatische Vorrichtung vorgesehen ist, welche beispielsweise an der Fläche des Türblattes (1) befestigt ist und durch ein mechanisch wirkendes Gestänge (6) die Drehung des Abschirmelementes (3) um seine Längsachse (2) bewirkt.

3. Metallische Abschirmtür nach Anspruch 1, dadurch gekennzeichnet, daß als krafterzeugendes Element ein mechanisch wirkendes Stellglied, beispielsweise in der Fläche der Tür angeordnete Handhebel oder federnde Kraftspeicher mit elektrischer Auslösung vorgesehen sind.

## Claims

1. A metal screening door, in particular for the screening of electromagnetic interference fields, in which, at its lower end, the door panel (1) is provided with a screening element (3) which at its surface facing the door sill (4), carries a spring contact element (5) which can be pressed against the door sill when the door is closed, the pressing being effected by power-transmitting auxiliary means, characterised in that at the lower end of the door panel (1), the screening element (3) is so constructed as to be pivotable about an axis (2) running along the end thereof.

2. A metal screening door according to Claim 1, characterised in that an electro-hydraulic, preferably an electro-pneumatic, device is provided as a power-producing element, said device being fixed, for example, to the surface of the door panel (1) and which device effects rotation of the screening element (3) about its longitudinal axis (2) by means of mechanically operating rods (6).

3. A metal screening door according to Claim 1, characterised in that, as a power-producing element, there is provided a mechanically-operating adjusting element, for example, a hand lever arranged at the surface of the door, or a spring-loaded, electricallytripped energy storage device.

## Revendications

1. Porte métallique blindée, en particullier pour former un écran pour des champs électromagnetiques de dispersion, dans laquelle le panneau de porte (1) est pourvu, à son extrémité inférieure, d'un élément (3) formant écran et qui porte, au niveau de la surface tournée vers le seuil de porte (4), un élément de contact élastique (5) susceptible d'être appliqué avec pression contre le seuil de porte, cette application ayant lieu à l'aide de moyens auxiliaires transmettant des forces, caractérisée par le fait que l'élément (3) formant écran est réalisé à l'extrémité inférieure du panneau de porte (1) de façon à pouvoir y basculer autour d'un axe qui s'étend le long de l'extrémité dudit panneau de porte.

2. Porte métallique blindée selon la revendication 1, caractérisée par le fait qu'il est prévu, au titre d'élément produisant des forces, un dispositif électro-hydraulique, de préférence électrol-pneumatique, qui est fixé par exemple à la surface du panneau de porte (1) et qui provoque par une tringlerie (6) à action mécanique une rotation de l'élément (3) formant écran autour de son axe longitudinal (2).

3. Porte métallique blindée selon la revendication 1, caractérisé par le fait que l'on prévoit, au titre d'élément produisant des forces, un organe de réglage à action mécanique, par exemple des leviers à main ou des accumulateurs de forces élastiques à déclenchement électrique, disposés dans la surface de la porte.

FIG. 1

FIG. 2